# EUROPEAN PATENT SPECIFICATION

(11) **EP 0 848 384 B1**
(45) Date of publication and mention of the grant of the patent: **13.10.2004**
(21) Application number: 97121895.3
(22) Date of filing: 12.12.1997
(51) Int. Cl.: G11C 16/04, G11C 16/06

(54) **Improvements in or relating to semiconductor devices**
Verbesserungen an oder in Bezug auf Halbleiteranordnungen
Améliorations dans ou relatives aux dispositifs semi-conducteurs

(30) Priority: 13.12.1996 US 32847 P
(43) Date of publication of application: 17.06.1998
(73) Proprietor: Texas Instruments Incorporated, Dallas, Texas 75265 (US)
(72) Inventor: Kaya, Cetin, Dallas, TX 75243 (US)
(74) Representative: Harris, Ian Richard

(56) References cited:
- EP-A- 0 616 334
- EP-A- 0 658 904
- US-A- 5 243 559
- US-A- 5 457 652
- US-A- 5 491 657

## Description

### TECHNICAL FIELD OF THE INVENTION

The present invention relates generally to semiconductor devices and, more particularly, to memory devices such as EPROMs and Flash EPROMs and, even more particularly, to a channel hot electron (CHE) programmed memory device having improved reliability and operability.

### BACKGROUND OF THE INVENTION

CHE programming of electrically erasable programmable read-only memories EPROMs and flash EPROMs can generate between 50µA-100µA of cell current. For state of the art devices, which are often built onto P-type epitaxial layers over a low resistivity substrate, this substrate current sinks into the low resistivity layer and does not generate significant voltage drop. However, for EPROMs and flash EPROMs that use a non-epitaxial layer substrate, or that are built on an isolated P-well surrounded by a deep N-well, such as in a triple well process, the substrate current that is generated during programming can build up large voltage drops across the resistive FAMOS P-well region.

If voltage drop exceeds the diode turn-"ON" voltage of approximately 0.7 volts, then the source junction will forward bias. This problem of the resistive P-well situation may be seen in a lowering of the floating-gate avalanche-injection metal oxide semiconductor (FAMOS) BVCEO voltage value. Lowering the BVCEO values, unfortunately, reduces the maximum drain potential of the device. For a constant current programming load line, this reduces the gate current and degrades programmability of the EPROM or flash EPROM.

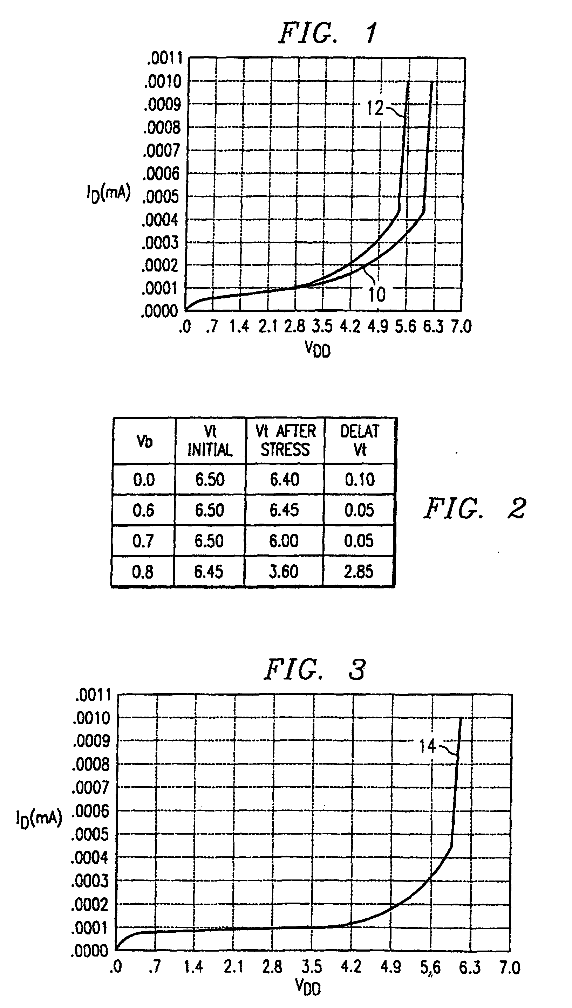

Figures 1 and 2 show the adverse effects of lower and BVCEO voltage values. In particular, Figure 1 illustrates a plot of two BVCEO characteristic lines for a flash EPROM cell built over a triple well structure that includes an isolated P-well within a deep N-well. In the first case of line 10, the isolated P-well is well grounded and the deep N-well potential is at ground potential. The resistance R equals 15Ω. In the second case of line 12, the isolated P-well is simulated to be resistive at a value of 15KΩ. Line 10 shows the shift in the BVCEO characteristic that yields a lowered programming voltage and generally degrades performance of the memory.

Another problem that arises when the substrate current builds up a voltage drop across the resistive FAMOS P-well is that once the source junction forward biases, it sprays electrons into the substrate. Some of the electrons will be collected by the drain junctions of the adjacent cells in the bit line stress mode. In this case, electrons entering the high electric field region near the drain create hot electron-holes pairs. Due to the polarity of the gate field near the drain, these hot electron-hole pairs are likely to be injected into the gate oxide and cause charge loss from the floating gate.

The table of Figure 2 shows the effect of rising body potential on bit line stress. In the table of Figure 2, the gate voltage, V_{g} equals zero; the drain voltage, V_{d}, equals six volts; and the source voltage, Vₛ, equals zero. Bit line stress occurs for approximately one second, in this example. The parameter, V_{b}, represents the bins voltage across the resistive FAMOS P-well region. As the Figure 2 table shows, with V_{b} exceeding 0.7 volts, the threshold voltage, Vₜ values of 0.10, 0.05 and 0.5 when V_{b} was at or below 0.7 volts. The lowered Vₜ, therefore, indicates the degraded programmability that breakdown of the source junction diode causes. Basically, as the substrate potential rises, the charge loss from floating gate rises correspondingly. This phenomenon exhibits an approximately exponential cause and effect relationship. Also, there is some expectation that the above-stated bit line stress mechanism causes grain degradation in flash memory devices as a result the hot hole injection.

To avoid the above issues, the voltage drop in the substrate during programming should stay below the diode turn "ON" voltage of approximately 0.7 volts. One way to achieve this result is to reduce the FAMOS P-well sheet resistance. Unfortunately, for triple well technology, this solution increases the process complexity. Therefore, there is a desire to build single isolated P-well to meet the CMOS requirements for negative voltage switching, and use the same isolated well for FAMOS devices. In this case, the high sheet resistance of the isolated P-well cannot meet the FAMOS requirements. For large arrays, the substrate bias build-up during programming forward biases the source junction and cause the above-stated device reliability concerns.

Other known solutions to this problem are process-orientated, using either a low-sheet-resistance FAMOS P-well or a very high energy implant. Both solutions, however, increase the process and the devices-design complexities.

One example existing solution is given in document EP 0 616 334. This document discloses a memory cell structure for an electrically erasable programmable read only memory (EPROM). The memory cell structure comprises a p-substrate having formed therein an n-type well region. Formed within the n-well region is a further p-type region isolated from the p-type substrate by the n-type well region. Formed within the p-type well region is an n-type source region and an n-type drain region. A gate is provided at a position between the source region and the drain region.

### SUMMARY OF THE INVENTION

In light of the above limitations, there is a need for a CHE programmed memory device having improved reliability and operability that substantially eliminates or reduces problems of forward biasing the isolated p-well junction and emitting electrons into the P-substrate, without the undesirable process and device design complexities that affect exist methods and devices.

Viewed from a first aspect, the present invention provides a channel hot electron programmed memory device of a type set out in claim 1. It has improved reliability and operability that avoids forward biasing at the isolated p-well junction and emitting electrons into the substrate by slightly forward biasing the deep-well with respect to the p-well. Viewed from another aspect, the present invention provides a method for improving the operation of a channel hot electron programmed memory device as set out in claim 8 and viewed from a further aspect, the present invention provides a method for forming a channel hot electron programmed device as set out in claim 13. In a preferred embodiment of the present invention, the forward bias is applied as a voltage to the deep N-well in the range of -0.3V - 0.5V, or a negative constant current of approximately -10µA, that is pumped into the deep N-well with isolated P-well being grounded. With the isolated P-well/deep N-well diode slightly forward biased, any substrate current generated during programming can easily forward bias this diode more. This results in pumping holes into the P-substrate. In that case, the isolated P-well potential does not rise more than 0.2V - 0.3V. This essentially eliminates the problems of forward biasing the isolated P-well junction and spraying electrons into the P-substrate.

A technical advantage of the present invention is that it makes use of resistive isolated P-wells in triple well designs practical by diverting the substrate current into the low resistivity P-substrate during programming. The present invention simplifies the process of building a flash EPROM array over a triple well by eliminating the requirement for a separate low-sheet-resistance, FAMOS P-well, thereby reducing fabrication costs. The present invention does not require an additional well and requires only a small circuit change. Moreover, present the invention is useful for all EPROMs built on triple wells.

### BRIEF DESCRIPTION OF THE DRAWINGS

For a more complete understanding of the present invention and the advantages thereof, reference is now made to the following exemplary description which is to be taken in conjunction with the accompanying drawings in which like reference numerals indicate like features and wherein:
Figure 1 shows a plot of BVCEO as a function of drain current that occurs in a flash EPROM that uses a non-epitaxial layer over a deep N-well, such as in a triple well process;
Figure 2 provides a table summarising the disadvantages efforts of the rising body potential on bit line stress;
Figure 3 provides a plot of BVCEO as a function drain current that occurs in a flash EPROM such as that to which Figures 1 and 2 relate, but which employs the teachings of the present invention;
Figure 4 depicts an embodiment of the present invention; and
Figure 5 shows an alternative embodiment of the present invention.

### DETAILED DESCRIPTION OF THE INVENTION

Preferred embodiments of the present invention are illustrated in the Figures like numerals being used to refer to like and corresponding parts of the various drawings.

Figure 3 illustrates a BVCEO line 14 showing the results of applying the concepts for which R_{B} = 15 Ohms and the deep N-well current is constant at -5µA, to yield a deep N-well potential of approximately -0.4V. By pumping a slightly negative voltage into the deep N-well no shift in the BVCEO characteristic curve occurs, as was the case in the BVCEO plots of Figure 1. Accordingly, no reduction in Vₜ after bitline stress occurs. The result is that no degradation in programmability or gate current reduction occurs.

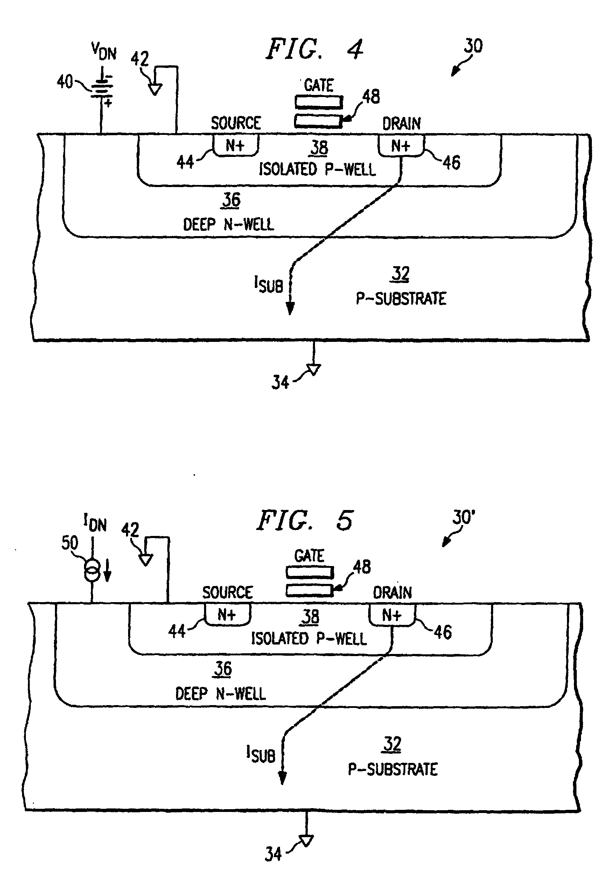

Figure 4 shows a embodiment of the present invention that includes memory cell 30 formed on P-substrate 32 which itself is grounded at ground connection 34. Forming the components of memory cell 30 may use any of a variety of known fabrication processes. Deep N-well 36 surround isolated P-well 38. Instead of grounding deep N-well 36, a slightly negative voltage V_{DN} of approximately -0.4V is applied to deep N-well 36 at connection 40. Isolated P-well 38 is grounded at ground potential connection 42. Within isolated P-well 38, N⁺ region 44 for forming the memory cell source region and N⁺ region 46 for forming the associated drain region. Gate dielectric region 48 is positioned over isolated P-well 38 between source N⁺ region 44 and drain N⁺ region 46.

Figure 5 illustrates an alternative embodiment with reference numerals generally corresponding to the elements of Figure 4. Figure 5, however, shows deep N-well current source 50, instead of deep N-well voltage source 40, connecting to deep N-well 36. Current source 50 pumps a negative current of approximately -10µA into deep N-well 36. Isolated P-well 38 is grounded, as before. With the junction between deep N-well 36 and isolated P-well 38 slightly forwarded biased, any current, I_{SUB}, within P-substrate 32. The result is that the potential of isolated P-well 38 will not exceed 0.2-0.3 volts. This essentially eliminates the reduced gate current and programmability problems of prior art devices.

Although the invention has been described in detail herein with reference to certain illustrative embodiments, it is to be understood that this description is by way of example only and is not to be construed in a limiting sense. It is to be further understood, therefore, that numerous changes in the details of the embodiments of the invention and additional embodiments of the invention, will be apparent to, and may be made by, persons of ordinary skill in the art having reference to this description.

## Claims

1. A channel hot electron programmed memory device, comprising:
a deep N-well region (36) disposed within a P-substrate (32);
an isolated P-well region (38) disposed within said N-well region (36);
a first current guiding N-doped region (44) disposed within said isolated P-well region (38);
a second current guiding N-doped region (46) disposed within said isolated P-well region (38);
a gate region (48) disposed between said first current guiding region (44) and said second current guiding region (46); and
**characterised by** the device further comprising:
a forward bias circuit connected to said deep N-well region for forward biasing said deep N-well region with respect to said isolated P-well region by maintaining said deep N-well region at a potential that is less than a potential of said P-well region while maintaining the voltage drop of a junction substantially between said isolated P-well region and said deep N-well region below a diode turn-on voltage.

2. The device of Claim 1, wherein said forward bias circuit (50) comprises a current bias circuit for pumping a bias current into said deep N-well region (36).

3. The device of Claim 1, wherein said forward bias circuit (40) comprises a voltage bias circuit for supplying a bias current to said deep N-well region (36).

4. The device of any of claims 1 to 3, wherein said memory device comprises an electrically erasable, programmable read-only memory.

5. The device of any of claims 1 to 3, wherein said memory device comprises a flash electrically erasable, programmable read-only memory.

6. The device of Claim 1,Claim 3, Claim 4 or Claim 5, wherein said forward bias circuit (40) comprises a voltage bias for applying a voltage sufficient to limit a potential of said isolated P-well to not greater than approximately 0.3 volts.

7. The device of Claim 1, Claim 2, Claim 4 or Claim 5, wherein said forward bias circuit (50) comprises a current source bias circuit for applying a current sufficient to limit a potential of said isolated P-well to not greater than approximately 0.3 volts.

8. A method for improving the operation of a channel hot electron programmed memory device comprising a deep N-well region (36) disposed within a P-substrate (32), an isolated P-well region (38) disposed within said N-well region (36), a first current guiding n-doped region (44) disposed within said isolated P-well region (38), a second current guiding n-doped region (46) disposed within said isolated P-well region (38), and a gate region (48) disposed substantially between said first and second current guiding regions (44, 46), **characterised by** the method comprising:
forward biasing the deep N-well region with respect to said isolated P-well region by maintaining said deep N-well region at a potential that is less than a potential of said P-well region while maintaining the voltage drop of a junction substantially between said isolated P-well region and said deep N-well region below a diode turn-on voltage.

9. The method of Claim 8, wherein said forward biasing step comprises the step of dumping a bias current into said deep N-well region (36).

10. The method of Claim 8, wherein said forward biasing step comprises the step of supplying a bias current to said deep N-well region (36).

11. The method of Claim 8, wherein said forward biasing step comprises the step of applying a voltage sufficient to limit the isolated P-well potential to not greater than approximately 0.3 volts.

12. The method of Claim 8, wherein said forward biasing step comprises the step of applying a current sufficient to limit the isolated P-well potential to not greater than approximately 0.3 volts.

13. A method for forming a channel hot electron programmed memory device, comprising the steps of:
forming a deep N-well region (36) within a P-substrate (32);
forming an isolated P-well region (38) within said N-well region (36);
forming a first current guiding N-doped region (44) within said isolated P-well region (38);
forming a second current guiding N-doped region (46) within said isolated P-well region (38); and
forming a gate region (48) between said first and said second current guiding regions (44, 46);
**characterised by** the method further comprising:
forming a forward bias circuit connected to said deep N-well region for forward biasing said deep N-well region with respect to said isolated P-well region by maintaining said deep N-well region at a potential that is less than a potential of said P-well region while maintaining the voltage drop of a junction substantially between said isolated P-well region and said deep N-well region below a diode turn-on voltage.

14. The method of Claim 13, wherein said forward bias circuit forming step comprises the step of forming a current bias circuit (50) for dumping a bias current into said N-well (36).

15. The method of Claim 13, wherein said forward bias circuit forming step comprises the step of forming a voltage bias circuit (40) for supplying a bias current to said deep N-well region (36).

16. The method of any of Claims 13 to 15, further comprising providing a memory device comprising an electrically erasable, programmable read-only memory.

17. The method of any of Claims 13 to 15, further comprising providing a memory device comprising a flash electrically programmable read-only memory.

18. The method of Claim 13,Claim 15, Claim 16 or Claim 17, wherein said forward bias circuit forming step comprises the step of forming a voltage bias circuit for applying a voltage sufficient to limit the isolated P-well potential to not greater then approximately 0.3 volts.

19. The method of Claim 13, wherein said forward bias circuit forming step further comprises the step of forming a current source bias circuit for applying a current sufficient to limit the isolated P-well potential to not greater than approximately 0.3 volts.

## Patentansprüche

1. Programmiertes Kanal-Heißelektronen-Speicherbauelement, welches aufweist:
einen tiefen N-Wannenbereich (36), der innerhalb eines P-Substrats (32) angeordnet ist,
einen isolierten P-Wannenbereich (38), der innerhalb des N-Wannenbereichs (36) angeordnet ist,
einen ersten stromführenden N-dotierten Bereich (44), der innerhalb des isolierten P-Wannenbereichs (38) angeordnet ist,
einen zweiten stromführenden N-dotierten Bereich (46), der innerhalb des isolierten P-Wannenbereichs (38) angeordnet ist,
einen Gate-Bereich (48), der zwischen dem ersten stromführenden Bereich (44) und dem zweiten stromführenden Bereich (46) angeordnet ist,
**dadurch gekennzeichnet, daß** die Vorrichtung weiter aufweist:
eine Durchlaßrichtungs-Vorspannungsschaltung, die mit dem tiefen N-Wannenbereich verbunden ist, um den tiefen N-Wannenbereich in bezug auf den isolierten P-Wannenbereich in Durchlaßrichtung vorzuspannen, indem der tiefe N-Wannenbereich auf einem Potential gehalten wird, das kleiner als ein Potential des P-Wannenbereichs ist, während der Spannungsabfall eines Übergangs im wesentlichen zwischen dem isolierten P-Wannenbereich und dem tiefen N-Wannenbereich unter einer Dioden-Durchschaltspannung gehalten wird.

2. Bauelement nach Anspruch 1, wobei die Durchlaßrichtungs-Vorspannungsschaltung (50) eine Strom-Vorspannungsschaltung zum Pumpen eines Vorspannungsstroms in den tiefen N-Wannenbereich (36) aufweist.

3. Bauelement nach Anspruch 1, wobei die Durchlaßrichtungs-Vorspannungsschaltung (40) eine Spannungs-Vorspannungsschaltung zum Zuführen eines Vorspannungsstroms zu dem tiefen N-Wannenbereich (36) aufweist.

4. Bauelement nach einem der Ansprüche 1 bis 3, wobei das Speicherbauelement einen elektrisch löschbaren, programmierbaren Nurlesespeicher aufweist.

5. Bauelement nach einem der Ansprüche 1 bis 3, wobei das Speicherbauelement einen elektrisch löschbaren, programmierbaren Flash-Nurlesespeicher aufweist.

6. Bauelement nach Anspruch 1, 3, 4 oder 5, wobei die Durchlaßrichtungs-Vorspannungsschaltung (40) eine Vorspannung zum Anlegen einer Spannung aufweist, die ausreicht, um ein Potential der isolierten P-Wanne auf nicht mehr als etwa 0,3 Volt zu begrenzen.

7. Bauelement nach Anspruch 1, 2, 4 oder 5, wobei die Durchlaßrichtungs-Vorspannungsschaltung (50) eine Stromquellen-Vorspannungsschaltung zum Anlegen eines Stroms aufweist, der ausreicht, um ein Potential der isolierten P-Wanne auf nicht mehr als etwa 0,3 Volt zu begrenzen.

8. Verfahren zum Verbessern der Arbeitsweise eines programmierten Kanal-Heißelektronen-Speicherbauelements mit einem tiefen N-Wannenbereich (36), der innerhalb eines P-Substrats (32) angeordnet ist, einem isolierten P-Wannenbereich (38), der innerhalb des N-Wannenbereichs (36) angeordnet ist, einem ersten stromführenden N-dotierten Bereich (44), der innerhalb des isolierten P-Wannenbereichs (38) angeordnet ist, einem zweiten stromführenden N-dotierten Bereich (46), der innerhalb des isolierten P-Wannenbereichs (38) angeordnet ist, und einem Gate-Bereich (48), der zwischen dem ersten stromführenden Bereich (44) und dem zweiten stromführenden Bereich (46) angeordnet ist,
**dadurch gekennzeichnet, daß** das Verfahren den folgenden Schritt aufweist:
Vorspannen des tiefen N-Wannenbereichs in Durchlaßrichtung in bezug auf den isolierten P-Wannenbereich, indem der tiefe N-Wannenbereich auf einem Potential gehalten wird, das kleiner als ein Potential des P-Wannenbereichs ist, während der Spannungsabfall eines Übergangs im wesentlichen zwischen dem isolierten P-Wannenbereich und dem tiefen N-Wannenbereich unter einer Dioden-Durchschaltspannung gehalten wird.

9. Verfahren nach Anspruch 8, wobei beim Vorspannen in Durchlaßrichtung ein Vorspannungsstrom in den tiefen N-Wannenbereich (36) abgeführt wird.

10. Verfahren nach Anspruch 8, wobei beim Vorspannen in Durchlaßrichtung ein Vorspannungsstrom dem tiefen N-Wannenbereich (36) zugeführt wird.

11. Verfahren nach Anspruch 8, wobei beim Vorspannen in Durchlaßrichtung eine Spannung angelegt wird, die ausreicht, um das Potential der isolierten P-Wanne auf nicht mehr als etwa 0,3 Volt zu begrenzen.

12. Verfahren nach Anspruch 8, wobei beim Vorspannen in Durchlaßrichtung ein Strom angelegt wird, der ausreicht, um das Potential der isolierten P-Wanne auf nicht mehr als etwa 0,3 Volt zu begrenzen.

13. Verfahren zum Bilden eines programmierten Kanal-Heißelektronen-Speicherbauelements mit den folgenden Schritten:
Bilden eines tiefen N-Wannenbereichs (36) innerhalb eines P-Substrats (32),
Bilden eines isolierten P-Wannenbereichs (38) innerhalb des N-Wannenbereichs (36),
Bilden eines ersten stromführenden N-dotierten Bereichs (44) innerhalb des isolierten P-Wannenbereichs (38),
Bilden eines zweiten stromführenden N-dotierten Bereichs (46) innerhalb des isolierten P-Wannenbereichs (38) und
Bilden eines Gate-Bereichs (48) zwischen dem ersten und dem zweiten stromführenden Bereich (44, 46),
**dadurch gekennzeichnet, daß** das Verfahren den weiteren Schritt aufweist:
Bilden einer Durchlaßrichtungs-Vorspannungsschaltung, die mit dem tiefen N-Wannenbereich verbunden ist, um den tiefen N-Wannenbereich in bezug auf den isolierten P-Wannenbereich in Durchlaßrichtung vorzuspannen, indem der tiefe N-Wannenbereich auf einem Potential gehalten wird, das kleiner als ein Potential des P-Wannenbereichs ist, während der Spannungsabfall eines Übergangs im wesentlichen zwischen dem isolierten P-Wannenbereich und dem tiefen N-Wannenbereich unter einer Dioden-Durchschaltspannung gehalten wird.

14. Verfahren nach Anspruch 13, wobei beim Bilden der Durchlaßrichtungs-Vorspannungsschaltung eine Strom-Vorspannungsschaltung (50) zum Abführen eines Vorspannungsstroms in die N-Wanne (36) gebildet wird.

15. Verfahren nach Anspruch 13, wobei beim Bilden der Durchlaßrichtungs-Vorspannungsschaltung eine Spannungs-Vorspannungsschaltung (40) zum Zuführen eines Vorspannungsstroms zu dem tiefen N-Wannenbereich (36) gebildet wird.

16. Verfahren nach einem der Ansprüche 13 bis 15, bei dem weiter ein Speicherbauelement mit einem elektrisch löschbaren, programmierbaren Nurlesespeicher bereitgestellt wird.

17. Verfahren nach einem der Ansprüche 13 bis 15, bei dem weiter ein Speicherbauelement mit einem elektrisch programmierbaren Flash-Nurlesespeicher bereitgestellt wird.

18. Verfahren nach Anspruch 13, 15, 16 oder 17, wobei beim Bilden der Durchlaßrichtungs-Vorspannungsschaltung eine Spannungs-Vorspannungsschaltung zum Anlegen einer Spannung, die ausreicht, um das isolierte P-Wannenpotential auf nicht mehr als etwa 0,3 Volt zu begrenzen, gebildet wird.

19. Verfahren nach Anspruch 13, wobei beim Bilden der Durchlaßrichtungs-Vorspannungsschaltung weiter eine Stromquellen-Vorspannungsschaltung zum Zuführen eines Stroms, der ausreicht, um das Potential der isolierten P-Wanne auf nicht mehr als etwa 0,3 Volt zu begrenzen, gebildet wird.

## Revendications

1. Dispositif de mémoire programmé avec canal à électron chaud, comprenant :
une région de puits n profond (36) disposée dans un substrat P (32) ;
une région de puits p isolé (38) disposée dans ladite région de puits n (36) ;
une première région dopée N (44) de guidage du courant disposée dans ladite région de puits p isolé (38) ;
une seconde région dopée N (46) de guidage du courant disposée dans ladite région de puits p isolé (38) ;
une région de barrière électronique (48) disposée entre ladite première région de guidage du courant (44) et ladite seconde région de guidage du courant (46) ; et
**caractérisé en ce que** le dispositif comprend en outre :
un circuit de polarisation en sens direct connecté à ladite région de puits n profond pour polariser en sens direct ladite région de puits n profond par rapport à ladite région de puits p isolé en maintenant ladite région de puits n profond à un potentiel inférieur au potentiel de ladite région de puits p, tout en maintenant la chute de tension d'une jonction principalement entre ladite région de puits p isolé et ladite région de puits n profond sous une tension d'allumage de diode.

2. Dispositif selon la revendication 1, dans lequel ledit circuit de polarisation en sens direct (50) comprend un circuit de polarisation de courant pour pomper un courant de polarisation dans ladite région de puits n profond (36).

3. Dispositif selon la revendication 1, dans lequel ledit circuit de polarisation en sens direct (40) comprend un circuit de polarisation de tension pour fournir un courant de polarisation à ladite région de puits n profond (36).

4. Dispositif selon l'une quelconque des revendications 1 à 3, dans lequel ledit dispositif de mémoire comprend une mémoire en lecture seule programmable et effaçable électriquement.

5. Dispositif selon l'une quelconque des revendications 1 à 3, dans lequel ledit dispositif de mémoire comprend une mémoire flash en lecture seule programmable et effaçable électriquement.

6. Dispositif selon la revendication 1, la revendication 3, la revendication 4 ou la revendication 5, dans lequel ledit circuit de polarisation en sens direct (40) comprend une polarisation de tension pour appliquer une tension suffisante pour limiter un potentiel dudit puits p isolé à une valeur ne dépassant pas environ 0,3 volts.

7. Dispositif selon la revendication 1, la revendication 2, la revendication 4 ou la revendication 5, dans lequel ledit circuit de polarisation en sens direct (50) comprend un circuit de polarisation de source du courant pour appliquer un courant suffisant pour limiter un potentiel dudit puits p isolé à une valeur ne dépassant pas environ 0,3 volts.

8. Procédé pour améliorer l'opération d'un dispositif de mémoire programmé avec canal à électron chaud comprenant une région de puits n profond (36) disposée dans un substrat P (32), une région de puits p isolé (38) disposée dans ladite région de puits n (36), une première région dopée N (44) de guidage du courant disposée dans ladite région de puits p isolé (38), une seconde région dopée N (46) de guidage du courant disposée dans ladite région de puits p isolé (38) et une région de barrière électronique (48) disposée principalement entre ladite première et ladite seconde région de guidage du courant (44, 46), **caractérisé en ce que** le procédé comprend l'étape consistant à :
polariser en sens direct la région de puits n profond par rapport à ladite région de puits p isolé en maintenant ladite région de puits n profond à un potentiel inférieur au potentiel de ladite région de puits p, tout en maintenant la chute de tension d'une jonction principalement entre ladite région de puits p isolé et ladite région de puits n profond sous une tension d'ouverture de diode.

9. Procédé selon la revendication 8, dans lequel ladite étape consistant à polariser en sens direct comprend l'étape consistant à pomper un courant de polarisation dans ladite région de puits n profond (36).

10. Procédé selon la revendication 8, dans lequel ladite étape consistant à polariser en direct comprend l'étape consistant à fournir un courant de polarisation à ladite région de puits n profond (36).

11. Procédé selon la revendication 8, dans lequel ladite étape consistant à polariser en sens direct comprend l'étape consistant à appliquer une tension suffisante pour limiter le potentiel de puits n isolé à une valeur ne dépassant pas environ 0,3 volts.

12. Procédé selon la revendication 8, dans lequel ladite étape consistant à polariser en sens direct comprend l'étape consistant à appliquer un courant suffisant pour limiter le potentiel de puits p isolé à une valeur ne dépassant pas environ 0,3 volts.

13. Procédé pour former un dispositif de mémoire programmé avec canal à électron chaud, comprenant les étapes consistant à :
former une région de puits n profond (36) dans un substrat P (32) ;
former une région de puits p isolé (38) dans ladite région de puits n (36) ;
former une première région dopée N (44) de guidage du courant dans ladite région de puits p isolé (38) ;
former une seconde région dopée N (46) de guidage du courant dans ladite région de puits p isolé (38) ; et
former une région de barrière électronique (48) entre ladite première région et ladite seconde région de guidage du courant (44, 46) ;
**caractérisé en ce que** le procédé comprend en outre l'étape consistant à :
former un circuit de polarisation en sens direct connecté à ladite région de puits n profond pour polariser en sens direct ladite région de puits n profond par rapport à ladite région de puits p isolé en maintenant ladite région de puits n profond à un potentiel inférieur au potentiel de ladite région de puits p, tout en maintenant la chute de tension d'une jonction principalement entre ladite région de puits p isolé et ladite région de puits n profond sous une tension d'ouverture de diode.

14. Procédé selon la revendication 13, dans lequel ladite étape consistant à former le circuit de polarisation en sens direct comprend l'étape consistant à former un circuit de polarisation du courant (50) pour vider un courant de polarisation dans ledit puits n (36).

15. Procédé selon la revendication 13, dans lequel ladite étape consistant à former ledit circuit de polarisation en sens direct comprend l'étape consistant à former un circuit de polarisation de tension (40) pour fournir un courant de polarisation à ladite région de puits n profond (36).

16. Procédé selon l'une quelconque des revendications 13 à 15, comprenant en outre l'étape consistant à fournir un dispositif de mémoire comprenant une mémoire en lecture seule programmable et effaçable électriquement.

17. Procédé selon l'une quelconque des revendications 13 à 15, comprenant en outre l'étape consistant à fournir un dispositif de mémoire comprenant une mémoire flash en lecture seule programmable électriquement.

18. Procédé selon la revendication 13, la revendication 15, la revendication 16 ou la revendication 17, dans lequel ladite étape consistant à former un circuit de polarisation en sens direct comprend l'étape consistant à former un circuit de polarisation de tension pour appliquer une tension suffisante pour limiter le potentiel de puits p isolé à une valeur ne dépassant pas environ 0,3 volts.

19. Procédé selon la revendication 13, dans lequel ladite étape consistant à former le circuit de polarisation en sens direct comprend en outre l'étape consistant à former un circuit de polarisation de source de courant pour appliquer un courant suffisant pour limiter le potentiel de puits p isolé à une valeur ne dépassant pas environ 0,3 volts.
